(19) Europäisches Patentamt
European Patent Office
Office européen des brevets

(11) **EP 3 905 520 A1**

(12) **EUROPEAN PATENT APPLICATION**
published in accordance with Art. 153(4) EPC

(43) Date of publication:
**03.11.2021 Bulletin 2021/44**

(51) Int Cl.:
**H03H 9/02** *(2006.01)*

(21) Application number: **19902251.8**

(22) Date of filing: **26.11.2019**

(86) International application number:
**PCT/CN2019/121082**

(87) International publication number:
**WO 2020/134803 (02.07.2020 Gazette 2020/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.12.2018 CN 201811607891**

(71) Applicants:
• **Tianjin University**
**Tianjin 300072 (CN)**

• **Rofs Microsystem (Tianjin) Co., Ltd**
**Tianjin 300462 (CN)**

(72) Inventors:
• **ZHANG, Menglun**
**Tianjin 300072 (CN)**
• **YANG, Qingrui**
**Tianjin 300072 (CN)**
• **PANG, Wei**
**Tianjin 300072 (CN)**

(74) Representative: **Bandpay & Greuter**
**30, rue Notre-Dame des Victoires**
**75002 Paris (FR)**

(54) **BULK ACOUSTIC WAVE RESONATOR HAVING ASYMMETRIC ELECTRODE THICKNESS, FILTER, AND ELECTRONIC DEVICE**

(57) The present disclosure relates to a bulk acoustic resonator, including: a substrate; an acoustic mirror; a sandwich structure comprising a top electrode, a piezoelectric layer and a bottom electrode, wherein the overlapping parts of the top electrode, the piezoelectric layer, the bottom electrode and the acoustic mirror in the thickness direction of the resonator form an effective region; and an enhancement structure on one side of the sandwich structure, wherein the enhancement structure is used for reflecting acoustic waves to improve the Q value, and the thickness of the electrode located on the one side of the sandwich structure is smaller than the thickness of the electrode located on the other side of the sandwich structure. The present disclosure further relates to a filter and electronic equipment having the filter.

A100

Fig. 5a

**Description**

**Technical Field**

Embodiments of the present disclosure relate to the field of semiconductors, in particular to a bulk acoustic resonator, a filter having the resonator, and electronic equipment having the resonator or the filter.

**Background Art**

A film bulk acoustic resonator made by the longitudinal resonance of a piezoelectric film in the thickness direction has become a feasible alternative to surface acoustic wave devices and quartz crystal resonators in terms of mobile phone communication and highspeed serial data applications. A radio frequency front end bulk wave filter/duplexer provides superior filtering characteristics, such as low insertion loss, steep transition band, higher power capacity, and stronger electrostatic discharge (ESD) resistance. A high-frequency film bulk acoustic resonator with ultra-low frequency temperature drift has low phase noise, low power consumption and a large bandwidth modulation range. In addition, these miniature film resonators use CMOS-compatible processing technology on silicon substrates, which can reduce the unit cost and facilitate the final integration with CMOS circuits.

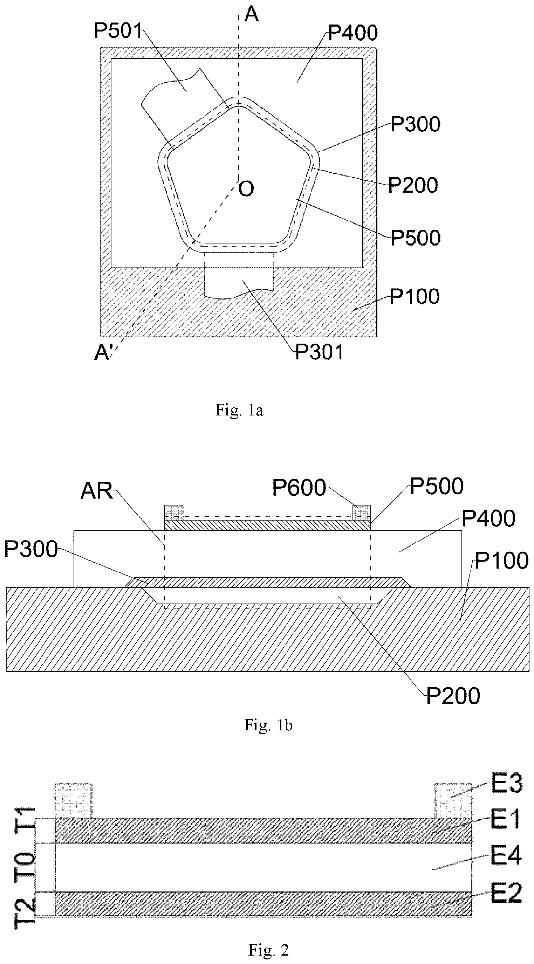

The bulk acoustic resonator structure shown in Fig. 1a and Fig. 1b specifically has a substrate P100; an acoustic mirror P200 is embedded into the substrate or is located on the surface of the substrate, the specific form of the acoustic mirror P200 may include a cavity or a Bragg reflecting layer or other equivalent structures capable of reflecting acoustic waves; a bottom electrode P300 covers the acoustic mirror structure and a part of the substrate; a piezoelectric film layer P400 covers the bottom electrode and a part of the substrate; and a top electrode P500 is located on the piezoelectric layer and covers a part of the piezoelectric layer, wherein the lateral overlapping part of the top electrode P500, the piezoelectric layer P400, the bottom electrode P300 and the cavity P200 defines an effective acoustic region AR of the bulk acoustic resonator. Generally, the bottom electrode BE and the top electrode TE further have electrode pins P301 and P501 as shown in Fig. 1a (not shown in Fig. 1b), respectively.

An enhancement structure P600 is further arranged on the surface of the top electrode or the bottom electrode (P600 in Fig. 1b is only a schematic diagram and does not represent a precise structure), the enhancement structure may include a protrusion structure for reflecting acoustic waves laterally propagating to the boundary of the effective region, thereby improving the Q value of the resonator.

In addition, in Fig. 1a and Fig. 1b, adjustment process layers that usually cover the surfaces of the functional layers such as P500 and P400 of the resonator are omitted. This type of process layers usually protects the resonator from the erosion of external water vapor and oxygen, or adjusts the performance parameters (such as frequency) of the resonator.

However, although the enhancement structure can be arranged to reflect the laterally propagating acoustic waves to improve the Q value, in reality, there is a need to further strengthen the acoustic wave reflection function.

**Summary of the Invention**

In order to alleviate or solve at least one aspect of the above-mentioned problems in the use of the prior art, the present disclosure is proposed.

According to one aspect of the embodiments of the present disclosure, a bulk acoustic resonator is provided, including: a substrate; an acoustic mirror; a sandwich structure comprising a top electrode, a piezoelectric layer and a bottom electrode, wherein the overlapping parts of the top electrode, the piezoelectric layer and the bottom electrode with the acoustic mirror in the thickness direction of the resonator form an effective region; and an enhancement structure arranged on one side of the sandwich structure, wherein: the thickness of the electrode located on the one side of the sandwich structure is smaller than the thickness of the electrode located on the other side of the sandwich structure.

Optionally, the ratio of the thickness of the electrode located on the other side of the sandwich structure to the thickness of the electrode located on one side of the sandwich structure is in the range of 1.1-2.5. Further, the ratio of the thickness of the electrode located on the other side of the sandwich structure to the thickness of the electrode located on one side of the sandwich structure is in the range of 1.5-2.25.

The embodiments of the present disclosure further relate to a filter, including the above-mentioned bulk acoustic resonator.

The embodiments of the present disclosure further relate to electronic equipment, including the above-mentioned bulk acoustic resonator or the above-mentioned filter.

**Brief Description of the Drawings**

The following description and the drawings can better help understand these and other features and advantages in various embodiments disclosed in the present disclosure. The same reference signs in the figures always denote the same components, wherein:

Fig. 1a is a schematic top view of a bulk acoustic resonator in the prior art;
Fig. 1b is a schematic cross-sectional view taken along a line AOA' in Fig. 1a;
Fig. 2 is a schematic diagram of a top electrode and a bottom electrode of a sandwich structure of the resonator in the prior art with equal thickness;

Fig. 3 is a diagram showing the relationship between an electromechanical coupling coefficient of the sandwich structure of the resonator and the thickness ratio of the two electrodes in the prior art;

Fig. 4 is a schematic diagram of a sandwich structure of a resonator according to an exemplary embodiment of the present disclosure;

Fig. 5a is a schematic diagram of a resonator according to an exemplary embodiment of the present disclosure;

Fig. 5b is an exemplary schematic diagram of an enhancement structure;

Fig. 5c is an optional exemplary schematic diagram of the enhancement structure;

Fig. 5d is a schematic diagram of a simulation result based on the enhancement structure in Fig. 5c;

Fig. 5e is a schematic diagram of a simulation result based on the enhancement structure in Fig. 5c;

Fig. 6 is a schematic diagram of a resonator according to an exemplary embodiment of the present disclosure;

Fig. 7 is a schematic diagram of a resonator according to an exemplary embodiment of the present disclosure;

Fig. 8 is a schematic diagram of a resonator according to an exemplary embodiment of the present disclosure;

Fig. 9 is an exemplary schematic diagram showing the relationship between the parallel resonance impedance of the resonator and the width of the enhancement structure;

Fig. 10 shows a dispersion curve of an S1 mode; and

Fig. 11 is a schematic diagram of a resonator according to an exemplary embodiment of the present disclosure, which shows a protruding enhancement structure and a recessed structure.

## Detailed Description of the Embodiments

The technical solutions of the present disclosure will be further described below in detail through embodiments and in conjunction with the drawings. In the specification, the same or similar reference signs indicate the same or similar components. The following description of the embodiments of the present disclosure with reference to the drawings is intended to explain the general inventive concept of the present disclosure, and should not be construed as a limitation to the present disclosure.

The present disclosure will be exemplarily described below with reference to the drawings.

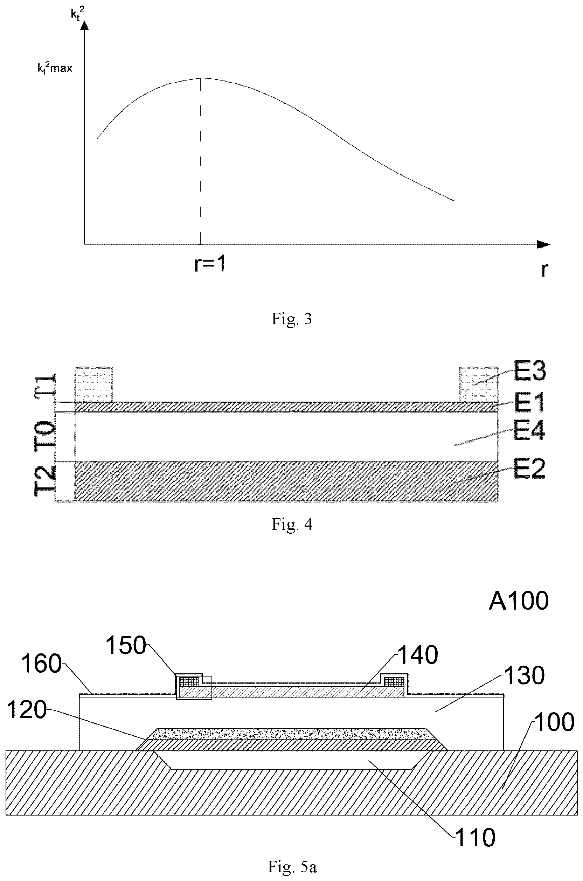

Fig. 2 is a schematic diagram of a top electrode and a bottom electrode of a sandwich structure of the resonator in the prior art with equal thickness; and Fig. 4 is a schematic diagram of a sandwich structure of a resonator according to an exemplary embodiment of the present disclosure.

As shown in Fig. 2 and Fig. 4, the sandwich structure includes a top electrode E1, a piezoelectric layer E4, a bottom electrode E2, and an enhancement structure E3 arranged at the end part of the top electrode E1. The enhancement structure is used for reflecting acoustic waves laterally propagating to the boundary of an effective region, thereby improving the Q value of the resonator.

The difference between Fig. 4 and Fig. 2 lies in that the thickness of the top electrode E1 becomes smaller, while the thickness of the bottom electrode E2 becomes greater. It can also be seen from Fig. 4 that the enhancement structure E3 is arranged on the side of the electrode with the reduced thickness.

If it is necessary to keep the frequency of the resonator shown in Fig. 2 unchanged in Fig. 4, it is also required that the thickness T1+T2+T0 of the sandwich structure in Fig. 2 is the same as the thickness T1+T2+T0 of the sandwich structure in Fig. 4.

Fig. 3 is a diagram showing the relationship between electromechanical coupling coefficient ($kt^2$) of the sandwich structure of the resonator and the thickness ratio r of the two electrodes in the prior art. Fig. 3 is a diagram showing the experiment and simulation results of the inventor. If other conditions remain unchanged, when the thicknesses of the top electrode and the bottom electrode are the same (that is, when the thickness ratio r of the electrodes is 1), the sandwich structure has the maximal electromechanical coupling coefficient ($kt^2max$), and the electromechanical coupling coefficient will be reduced by the electrodes with unequal thicknesses.

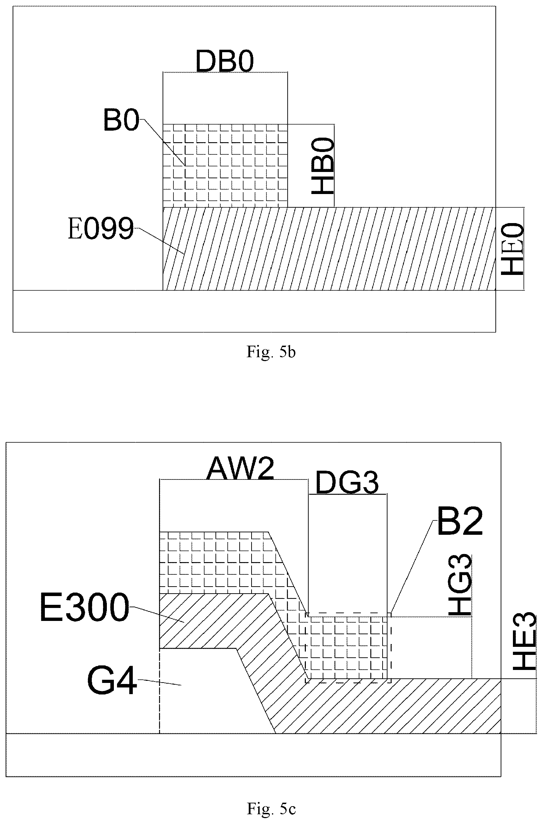

Fig. 5a is a schematic diagram of a resonator according to an exemplary embodiment A100 of the present disclosure; and Fig. 5b is an enlarged schematic diagram of the enhancement structure used in Fig. 5a.

The resonator structure in the embodiment A100 includes: a substrate 100, an acoustic mirror (cavity) 110, a bottom electrode 120, a piezoelectric layer 130, a top electrode 140, and an enhancement structure 150 located at the edge of the top electrode.

Optionally, the surface of the resonator may also be covered with other process layers 160 according to specific needs, such as passivation layers for preventing water vapor and inhibiting oxidation (the process layers are also applicable to subsequent embodiments and will not be shown in subsequent figures).

In the embodiment A100 , the thickness of the bottom electrode is greater than the thickness of the top electrode, and the thickness ratio of the bottom electrode to the top electrode is in the range of 1.1-2.5, and the further range is 1.5-2.25. It should be pointed out that this requirement includes the case where the process layer 160 is taken into consideration. Subsequent embodiments are similarly processed, that is, when the process layer is provided, the thickness ratio of the electrode on the side with no thickness reduction to the electrode on the side with thickness reduction still meets the above-mention proportional range when the thickness of the process layer is included. The ratio of the thickness of the electrode located on the other side of the sandwich structure to the thickness of the electrode located on one side of the sandwich structure may be 1.1, 1.3, 2.0, 2.25, 2.5, etc.

The bottom electrode 120 may be made of a single-layer metal material or an alloy, or a multilayer composite material.

When the top electrode and the bottom electrode are both made of a single-layer material, the metal materials adopted by the top electrode and the bottom electrode may be the same or different.

The enhancement structure 150 in Fig. 5a is only schematic and does not represent a specific structure, which is also the same in the subsequent embodiments.

An enhancement structure shown in Fig. 5b includes a blocky protrusion B0 located on the electrode E099, wherein the material of the blocky protrusion B0 may be the same as or different from that of the electrode E099. In Fig. 5b, the thickness of the blocky protrusion B0 is HB0, the width of the blocky protrusion B0 is DB0, and the thickness of the electrode E099 is HE0. In an optional embodiment, the width DB0 of the blocky protrusion B0 is in the range of 0.5 microns to 7 microns, for example, 0.5 microns, 1 micron, 2 microns, 5 microns, 7 microns, or the like; and optionally, DB0 is in the range of 0.5 microns to 2 microns, and it can also be 1/4 of the wavelength $\lambda$ of the transverse lamb wave in the S1 mode, or an odd multiple of 1/4 of the wavelength $\lambda$ of the lamb wave.

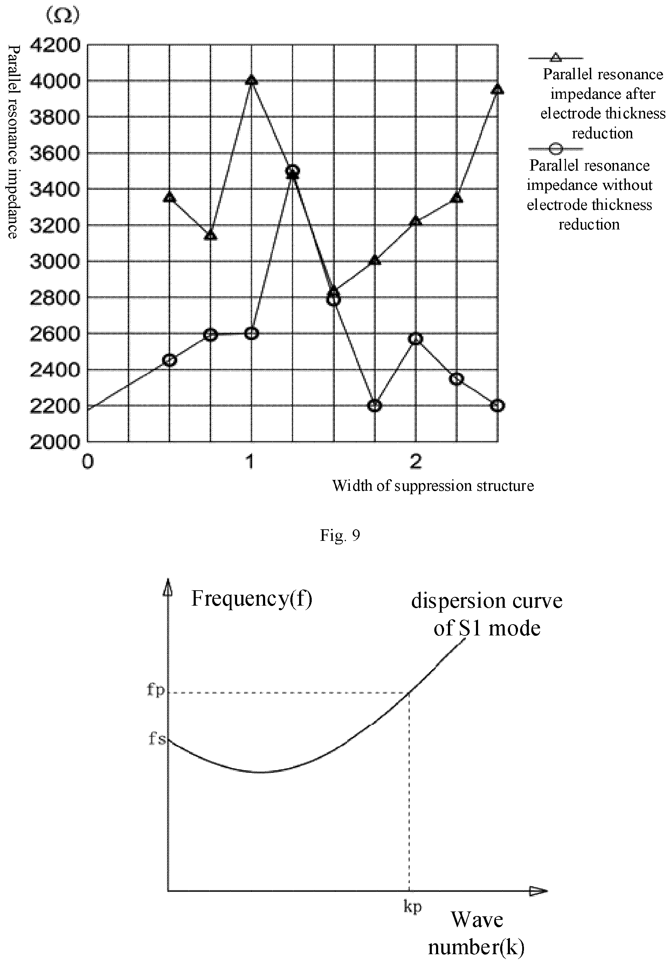

The S1 mode will be described below with reference to Fig. 10. As shown in Fig. 10, when the bulk acoustic resonator is working, a large number of vibrations are generated in the sandwich structure, if these vibrations are plotted as a dispersion curve according to the relationship between the frequency (f) and the wave number (k), the curves of a variety modes can be obtained, the curve of one mode is called the S1 mode (the curves of the other modes are not shown in Fig. 10), which has a dispersion curve of the shape shown in Fig. 10, wherein the abscissa represents the wave number and the vertical coordinate represents the vibration frequency. When the vibration frequency is parallel resonance frequency $f_p$, the corresponding wave number is $k_p$, and the wavelength $\lambda$ of the S1 mode is defined as the following formula:

$$\lambda = \frac{2\pi}{k_p}$$

In an optional embodiment, the thickness HE0 of the blocky protrusion B0 is in the range of 500-2500 Å, for example, may be 500 Å, 800 Å, 1400 Å, 2500 Å, and the like.

As shown in Fig. 5c, the electrode E300 of an airfoil structure has a protruding part, and the protruding part is defined as the part in a dotted line region B2, the width of the protruding part is defined as DG3, the width of the airfoil part is defined as AW2, and the thickness of the protruding dpart is defined as HG3. The thickness of the electrode E300 is HE3, and there is a gap G4 below the airfoil structure. The specific enhancement structure 150 is not limited to the form shown in Figs. 5b-5c, and may also be any other enhancement structures easily conceived by those skilled in the art.

Fig. 9 is an exemplary relationship diagram of an exemplary embodiment of the parallel resonance impedance of the resonator and the width of the enhancement structure, wherein the vertical axis represents the parallel resonance impedance of the resonator, the horizontal axis represents the width of the enhancement structure, the broken line with a triangle shows the parallel resonance impedance after the thickness of the electrode is reduced (that is, the thicknesses of the top electrode and the bottom electrode are different), and the broken line with a circle shows the parallel resonance impedance with the thickness ratio of the electrodes is 1.

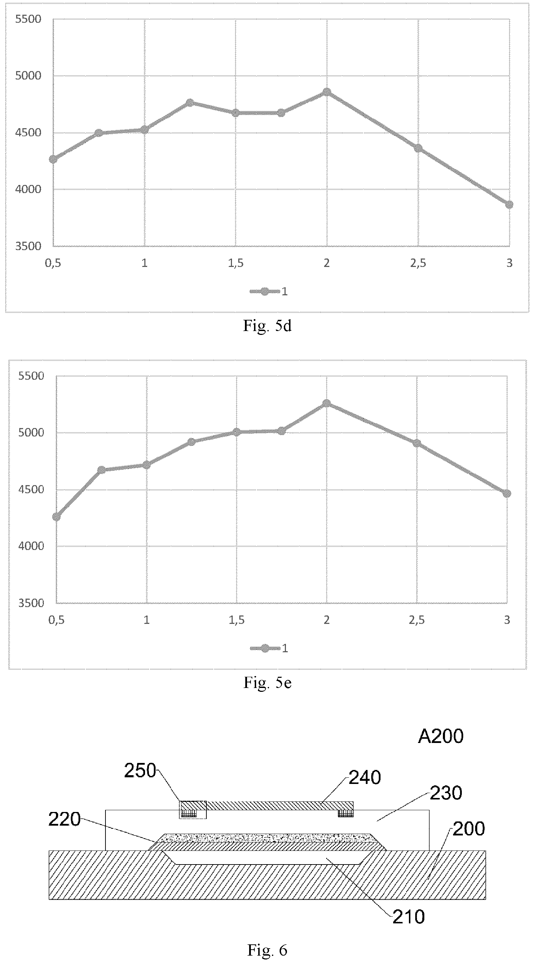

From the relationship diagram between the parallel resonant impedance and the width of the enhancement structure in Fig. 9, it can be seen that the parallel resonant impedance with an asymmetric structure (that is, the two electrodes have different thicknesses) is significantly higher than (the two curves only overlap within a small range) that in the case of an symmetrical structure (that is, the two electrodes have the same thickness) within the changing range of the width of the enhancement structure shown in the figure. As shown in Fig. 9, when the width of the enhancement structure is in the range of 0.5 microns to 1.25 microns, or not less than 1.5 microns, the parallel resonance impedance is greatly improved compared with the symmetrical arrangement structure with the same electrode thickness. Fig. 5d is a first simulation result diagram of the enhancement structure in Fig. 5c, wherein the simulation conditions are set as HG3=600Å; DG3=1 $\mu$m, and AW2=1 $\mu$m. The abscissa represents the ratio of the thickness of the electrode on the non-enhancement structure side to the thickness of the electrode on the enhancement structure side, and the vertical coordinate represents the parallel resonance impedance.

Fig. 5e is a second simulation result diagram of the enhancement structure in Fig. 5c, wherein the simulation conditions are set as HG3=1200Å; DG3=1$\mu$m, and AW2=1$\mu$m. The abscissa represents the ratio of the thickness of the electrode on the non-enhancement structure side to the thickness of the electrode on the enhancement structure side, and the vertical coordinate represents the parallel resonance impedance.

Fig. 5d and Fig. 5e exemplarily show changing curves of the parallel resonance impedance when the width of the enhancement structure is constant and the thickness ratios of the electrodes are different.

Based on Fig. 5d and Fig. 5e, it can be seen that only when the thickness of the enhancement structure changes from 600 Å to 1200 Å, the change trends of the curves are roughly the same.

The above exemplary description of the enhancement structure is also applicable to other embodiments of the present disclosure.

Fig. 6 is a schematic diagram of a resonator according to another exemplary embodiment A200 of the present disclosure. In Fig. 6, the thickness of the bottom electrode is greater than that of the top electrode. The difference between the embodiment A200 and the embodiment A100 lies in that the enhancement structure in the embodiment A200 is located on the lower surface of the top electrode. As shown in Fig. 6, the enhancement structure is a protrusion embedded into the piezoelectric layer 230. The enhancement structure may also be a cavity (which can be filled with a solid material or not) arranged on the upper surface of the piezoelectric layer 230 or the lower surface or the upper surface of the top electrode 240, and may also be a combination of a protrusion and a cavity or other forms.

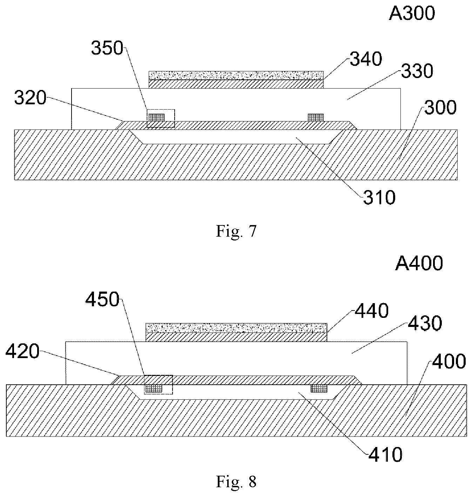

Fig. 7 is a schematic diagram of a resonator according to yet another exemplary embodiment A300 of the present disclosure. The difference between the embodiment A300 and the embodiments A100 and A200 lies in that: in the embodiment A300, the thickness of the bottom electrode is relatively small, and the enhancement structure is located on the upper surface of the bottom electrode. As shown in Fig. 7, the enhancement structure is a protrusion embedded into the piezoelectric layer 330.

Fig. 8 is a schematic diagram of a resonator according to still another exemplary embodiment A400 of the present disclosure. In the embodiment A400, the thickness of the bottom electrode is relatively small, and the enhancement structure is located on the lower surface of the bottom electrode. As shown in Fig. 8, the enhancement structure is a protrusion protruding into the cavity or a reflector 410.

Although in the present disclosure, the enhancement structure is arranged on the top electrode, the bottom electrode or the piezoelectric layer, for different reflector structures, the enhancement structure may also be arranged at other positions in the resonator.

In the present disclosure, if the thickness of the electrode on one side with the enhancement structure is decreased, and the thickness of the electrode on the other side is increased at the same time, the reflection performance of the enhancement structure for the laterally propagating acoustic waves can be effectively improved. The reflection performance is mainly reflected in the improvement effect of the asymmetric structure on the parallel resonance impedance of the resonator, and for the bulk acoustic resonator, the greater the parallel resonance impedance is, the better the performance is.

Based on Fig. 3, it can be seen that the electromechanical coupling coefficient of the resonator will be reduced in the solution in which the thicknesses of the two electrodes are different. In order to keep the electromechanical coupling coefficient unchanged, the present disclosure further proposes doping the piezoelectric layer to compensate the loss of the electromechanical coupling coefficient caused thereby.

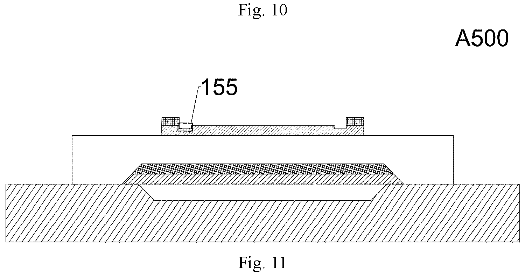

Fig. 11 shows a schematic diagram of a resonator according to an exemplary embodiment A500 of the present disclosure, wherein a protruding enhancement structure and a recessed structure are shown.

Based on the asymmetric structure of the electrode thicknesses, the acoustic wave reflection performance of the protruding enhancement structure can be improved, and the Q value of the resonator can be improved, but at the same time, clutter in a parasitic mode may also be enhanced. In order to overcome the above-mentioned problem, a "recessed" suppression structure (i.e., the recessed structure) can be added on the basis of the previous embodiment to suppress the acoustic waves in the above-mentioned parasitic mode.

The depth value of the recessed structure may be the same as the thickness value of the protruding enhancement structure, and the width value of the recessed structure may be the same as the width value of the protruding enhancement structure.

As shown in Fig. 11, the recessed structure 155 is arranged on the inner side of the protruding enhancement structure and adjacent to the protruding enhancement structure.

Correspondingly, the material of the piezoelectric layer can be selected from, but is not limited to: aluminum nitride, wherein the doping element includes: scandium (preferably), yttrium, magnesium, titanium, or other rare earth elements. The doping atomic fraction ranges from 1% to 40%, and preferably ranges from 3% to 20%. The specific atomic fraction may be 1%, 3%, 6%, 20%, 30%, 40%, and so on. In addition, zinc oxide, lithium niobate, or lead zirconate titanate (PZT) may also be used as the main material of the piezoelectric layer and are doped with the above elements. The aforementioned piezoelectric material is a thin film with a thickness less than 10 microns, wherein the aluminum nitride thin film is in a polycrystalline form or a single crystal form, and the growth mode is thin film sputtering or metal-organic chemical vapor deposition (MOCVD).

The material of the substrate can be selected from, but is not limited to: single crystal silicon, quartz, gallium arsenide or sapphire, etc.

The material of the electrode includes, but is not limited to: molybdenum, ruthenium, gold, magnesium, aluminum, tungsten, titanium, chromium, iridium, osmium, and the like, and multilayer composite materials or alloys of the above metals can also be used.

Based on the above description, the present disclosure proposes the following technical solutions:

1. A bulk acoustic resonator, including: a substrate; an acoustic mirror; a sandwich structure comprising a top electrode, a piezoelectric layer and a bottom electrode, wherein the overlapping parts of the top electrode, the piezoelectric layer , the bottom electrode and the acoustic mirror in the thickness direction of the resonator form an effective region; and an enhancement structure arranged on one side of the sandwich structure, wherein the thickness of the electrode located on the one side of the sandwich structure is smaller than the thickness of the electrode located on the other side of the sandwich structure.

2. The resonator according to 1, wherein: the top electrode includes a metal layer and a process layer arranged on the metal layer, and the sum of the thicknesses of the metal layer and the process layer is equal to the thickness of the top electrode.

3. The resonator according to 1, wherein: the thickness of the top electrode is greater than the thickness of the bottom electrode.

4. The resonator according to 1, wherein: the thickness of the top electrode is smaller than the thickness of the bottom electrode.

5. The resonator according to 1, wherein: the ratio of the thickness of the electrode located on the other side of the sandwich structure to the thickness of the electrode located on one side of the sandwich structure is in the range of 1.1-2.5.

6. The resonator according to 5, wherein: the ratio of the thickness of the electrode located on the other side of the sandwich structure to the thickness of the electrode located on one side of the sandwich structure is in the range of 1.5-2.25.

7. The resonator according to 1, wherein: the enhancement structure includes a protruding enhancement structure.

8. The resonator according to 7, wherein: the width of the protruding enhancement structure is in the range of 0.5 microns to 7 microns.

9. The resonator according to 8, wherein: the width of the protruding enhancement structure is in the range of 0.5 microns to 2 microns.

10. The resonator according to 7, wherein: the width of the protruding enhancement structure is 1/4 of the wavelength of the transverse lamb wave in the S1 mode, or an odd multiple of 1/4 of the wavelength of the lamb wave.

11. The resonator according to any one of 7-10, wherein: the protrusion thickness of the protruding enhancement structure is in the range of 500-2500 Å.

12. The resonator according to 11, wherein: the protrusion thickness of the protruding enhancement structure is in the range of 600-1200Å.

13. The resonator according to 7, wherein: the resonator further includes a recessed structure that is arranged on the inner side of the protruding enhancement structure and adjacent to the protruding enhancement structure.

14. The resonator according to 13, wherein: the width of the recessed structure is in the range of 0.5 microns to 7 microns; or the width of the recessed structure is 1/4 of the wavelength of the transverse lamb wave in the S1 mode, or an odd multiple of the wavelength of the lamb wave .

15. The resonator according to 14, wherein: the width of the recessed structure is in the range of 0.5 microns to 2 microns.

16. The resonator according to 13 or 14, wherein: the depth of the recessed structure is in the range of 500-2500 Å.

17. The resonator according to 16, wherein: the depth of the recessed structure is in the range of 600-1200 Å.

18. The resonator according to any one of 1-17, wherein: the piezoelectric layer is doped with one or more of the following elements: scandium, yttrium, magnesium, titanium, lanthanum, cerium, praseodymium, neodymium, promethium, samarium, europium, gadolinium, terbium, dysprosium, holmium, erbium, thulium, ytterbium and lutetium; and the atomic fraction of the doping element ranges from 1% to 40%.

19. The resonator according to 18, wherein: the atomic fraction of the doping element ranges from 3% to 20%.

20. The resonator according to 18 or 19, wherein: the piezoelectric layer is an aluminum nitride piezoelectric layer, a zinc oxide piezoelectric layer, a lithium niobate piezoelectric layer, or a lead zirconate titanate piezoelectric layer.

Correspondingly, the present disclosure further relates to a filter, including the above-mentioned resonator.

The present disclosure further relates to electronic equipment, including the above-mentioned resonator or filter. It should be pointed out that the electronic equipment here includes, but is not limited to, intermediate products such as radio frequency front ends, filter amplifier modules, and terminal products such as mobile phones, WIFI and drones.

Although the embodiments of the present disclosure have been shown and described, for those of ordinary skill in the art, it can understood that modifications can be made to these embodiments without departing from the principle and spirit of the present disclosure, and the scope of the present disclosure is defined by the appended claims and their equivalents.

## Claims

1. A bulk acoustic resonator, comprising:

    a substrate;
    an acoustic mirror;
    a sandwich structure comprising a top electrode, a piezoelectric layer and a bottom electrode, wherein the overlapping parts of the top electrode, the piezoelectric layer , the bottom electrode and the acoustic mirror in the thickness direction of the resonator form an effective region; and
an enhancement structure arranged on one side of the sandwich structure,
wherein:
the thickness of the electrode located on the one side of the sandwich structure is smaller than the thickness of the electrode located on the other side of the sandwich structure.

2. The resonator according to claim 1, wherein:
the top electrode comprises a metal layer and a process layer arranged on the metal layer, and the sum of the thicknesses of the metal layer and the process layer is equal to the thickness of the top electrode.

3. The resonator according to claim 1, wherein:
the thickness of the top electrode is greater than the thickness of the bottom electrode.

4. The resonator according to claim 1, wherein:
the thickness of the top electrode is smaller than the thickness of the bottom electrode.

5. The resonator according to any one of claims 1-4, wherein:
the ratio of the thickness of the electrode located on the other side of the sandwich structure to the thickness of the electrode located on one side of the sandwich structure is in the range of 1.1-2.5.

6. The resonator according to claim 5, wherein:
the ratio of the thickness of the electrode located on the other side of the sandwich structure to the thickness of the electrode located on one side of the sandwich structure is in the range of 1.5-2.25.

7. The resonator according to claim 1, wherein:
the enhancement structure comprises a protruding enhancement structure.

8. The resonator according to claim 7, wherein:
the width of the protruding enhancement structure is in the range of 0.5 microns to 7 microns.

9. The resonator according to claim 8, wherein:
the width of the protruding enhancement structure is in the range of 0.5 microns to 2 microns.

10. The resonator according to claim 7, wherein:
the width of the protruding enhancement structure is 1/4 of the wavelength of the transverse lamb wave in the S1 mode, or an odd multiple of 1/4 of the wavelength of the lamb wave.

11. The resonator according to any one of claims 7-10, wherein:
the protrusion thickness of the protruding enhancement structure is in the range of 500-2500 Å.

12. The resonator according to claim 11, wherein:
the protrusion thickness of the protruding enhancement structure is in the range of 600-1200Å.

13. The resonator according to claim 7, wherein:
the resonator further comprises a recessed structure that is arranged on the inner side of the protruding enhancement structure and adjacent to the protruding enhancement structure.

14. The resonator according to claim 13, wherein:
the width of the recessed structure is in the range of 0.5 microns to 7 microns; or the width of the recessed structure is 1/4 of the wavelength of the transverse lamb wave in the S1 mode, or an odd multiple of the wavelength of the lamb wave .

15. The resonator according to claim 14, wherein:
the width of the recessed structure is in the range of 0.5 microns to 2 microns.

16. The resonator according to claim 13 or 14, wherein:
the depth of the recessed structure is in the range of 500-2500 Å.

17. The resonator according to claim 16, wherein:
the depth of the recessed structure is in the range of 600-1200 Å.

18. The resonator according to any one of claims 1-17, wherein:
the piezoelectric layer is doped with one or more of the following elements: scandium, yttrium, magnesium, titanium, lanthanum, cerium, praseodymium, neodymium, promethium, samarium, europium, gadolinium, terbium, dysprosium, holmium, erbium, thulium, ytterbium and lutetium; and the atomic fraction of the doping element ranges from 1% to 40%.

19. The resonator according to claim 18, wherein:
the atomic fraction of the doping element ranges from 3% to 20%.

20. The resonator according to claim 18 or 19, wherein:
the piezoelectric layer is an aluminum nitride piezoelectric layer, a zinc oxide piezoelectric layer, a lithium niobate piezoelectric layer, or a lead zirconate titanate piezoelectric layer.

21. A filter, comprising:
the bulk acoustic resonator according to any one of claims 1-20.

**22.** Electronic equipment, comprising the bulk acoustic resonator according to any one of claims 1-20 or the filter according to claim 21.

Fig. 1a

Fig. 1b

Fig. 2

Fig. 3

Fig. 4

Fig. 5a

DB0

B0

HB0

E099

HE0

Fig. 5b

AW2

DG3

B2

HG3

E300

HE3

G4

Fig. 5c

Fig. 5d

Fig. 5e

Fig. 6

A300

Fig. 7

A400

Fig. 8

(Ω)

Parallel resonance impedance

4200
4000
3800
3600
3400
3200
3000
2800
2600
2400
2200
2000

0          1          2

Width of suppression structure

△ Parallel resonance
impedance after
electrode thickness
reduction

○ Parallel resonance
impedance without
electrode thickness
reduction

Fig. 9

Frequency(f)                    dispersion curve
of S1 mode

fp

fs

kp          Wave
number(k)

Fig. 10

A500

155

Fig. 11

## INTERNATIONAL SEARCH REPORT

<table>
<tr><td colspan="2">International application No.<br>**PCT/CN2019/121082**</td></tr>
</table>

**A.    CLASSIFICATION OF SUBJECT MATTER**

H03H 9/02(2006.01)i

According to International Patent Classification (IPC) or to both national classification and IPC

**B.    FIELDS SEARCHED**

Minimum documentation searched (classification system followed by classification symbols)

H03H

Documentation searched other than minimum documentation to the extent that such documents are included in the fields searched

Electronic data base consulted during the international search (name of data base and, where practicable, search terms used)

CNABS; CNKI; SIPOABS; DWPI: 体声波, 谐振器, 三明治, 增强, 电极, 厚度, acoustic, resonator, electrode, sandwich, piezoelectric layer

**C.    DOCUMENTS CONSIDERED TO BE RELEVANT**

| Category* | Citation of document, with indication, where appropriate, of the relevant passages | Relevant to claim No. |
|---|---|---|
| X | CN 104030234 A (JIANGSU ALLENMOORE MICROELECTRONICS CO., LTD.) 10 September 2014 (2014-09-10)<br>    description, paragraphs [0021]-[0026], and figure 1 | 1-22 |
| A | CN 107800396 A (CETC DEQING HUAYING ELECTRONICS CO., LTD.) 13 March 2018 (2018-03-13)<br>    entire document | 1-22 |
| A | CN 103490743 A (THE 13TH RESEARCH INSTITUTE OF CHINA ELETRONICS TECHNOLOGY GROUP CORPORATION) 01 January 2014 (2014-01-01)<br>    entire document | 1-22 |

☐ Further documents are listed in the continuation of Box C.          ☑ See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **26 February 2020** | **03 March 2020** |

| Name and mailing address of the ISA/CN | Authorized officer |
|---|---|
| **China National Intellectual Property Administration<br>No. 6, Xitucheng Road, Jimenqiao Haidian District, Beijing 100088<br>China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2019/121082**

| Patent document cited in search report | | | Publication date (day/month/year) | Patent family member(s) | | | Publication date (day/month/year) |
|---|---|---|---|---|---|---|---|
| CN | 104030234 | A | 10 September 2014 | CN | 104030234 | B | 13 January 2016 |
| CN | 107800396 | A | 13 March 2018 | None | | | |
| CN | 103490743 | A | 01 January 2014 | CN | 103490743 | B | 11 January 2017 |

Form PCT/ISA/210 (patent family annex) (January 2015)